# EUROPEAN PATENT APPLICATION

(11) **EP 4 832 050 A1**
(43) Date of publication of application: **28.10.2026**
(21) Application number: 24907176.2
(22) Date of filing: 05.12.2024
(51) Int. Cl.: H01L 21/304, B24B 37/00, C09G 1/02, C09K 3/14

(54) **POLISHING COMPOSITION**

(30) Priority: 19.12.2023 JP 2023213513
(71) Applicant: NITTA DuPont Incorporated, Osaka-shi, Osaka 556-0022 (JP)
(72) Inventor: OGAWA, Rina, Kyotanabe-shi, Kyoto 610-0333 (JP); HOSOKAWA, Koichiro, Kyotanabe-shi, Kyoto 610-0333 (JP)
(74) Representative: Stolmár & Partner Patentanwälte PartG mbB
(86) International application number: PCT/JP2024/043057
(87) International publication number: WO 2025/134790

(57) **Abstract**

A polishing composition includes abrasives, an amine compound, and water, in which the amine compound is at least one of 1,3-diaminopropane and 1,4-diaminobutane.

## Description

### CROSS-REFERENCE TO RELATED APPLICATION

This application claims priority to Japanese Patent Application No. 2023-213513, the disclosure of which is incorporated herein by reference.

### FIELD

The present invention relates to a polishing composition.

### BACKGROUND

Conventionally, chemical mechanical polishing (hereinafter, CMP) has been performed in the manufacture of semiconductor devices. In the manufacture of recent highly functional semiconductor devices, various objects to be polished are anticipated. Therefore, polishing compositions are also required to have polishing performance suited to the situation.

For example, a polishing composition of Patent Literature 1 is intended for polishing to expose copper electrodes embedded in a silicon layer, and includes, in addition to abrasives, an alkaline compound such as diamines and an oxidizing agent such as sodium chlorite. Patent Literature 1 discloses that the silicon layer and the copper layer can be polished at approximately the same polishing rate by using this polishing composition.

A polishing composition of Patent Literature 2 is applicable to shallow trench isolation (STI) in front-end-of-line (FEOL) processes, and is intended to preferentially polish a silicon oxide layer over a silicon nitride layer. Patent Literature 2 discloses that the above object can be achieved by using a polishing composition in which a core-shell structure is formed in colloidal silica with a hydrolyzed aminosilane material.

### CITATION LIST

### Patent Literature

Patent Literature 1: JP 2011-66383 A
Patent Literature 2: JP 2017-525793 T

### SUMMARY

### Technical Problem

Incidentally, in CMP for recent highly functional semiconductor devices, it may be required to polish a silicon layer such as a polysilicon layer together with a silicon oxide layer or a silicon nitride layer.

For example, in forming a gate structure of a field effect transistor such as GAA, after forming an insulating layer serving as an insulating partition of a gate electrode, a recess for forming the gate electrode is formed in this insulating layer, and a deposited layer of polysilicon is formed on the insulating layer while filling this recess with polysilicon. Then, CMP is performed to planarize an exposed surface of the gate electrode and the insulating layer while removing the deposited layer of silicon. Further, in forming such a gate structure, a protective layer called a cap layer can be formed between the insulating layer and the deposited layer. The cap layer is composed of one material of silicon oxide and silicon nitride, which is different from the material of the insulating layer. Then, CMP is performed to planarize or remove the cap layer while removing the deposited layer of silicon.

As exemplified above, it is anticipated that polishing of the deposited layer results in a relatively large amount of polishing. Therefore, in this situation, it is efficient to use a polishing composition with an increased polishing rate for silicon. On the other hand, it is anticipated that polishing of the insulating layer or the cap layer results in a relatively small amount of polishing. Therefore, in this situation, from the viewpoint of polishing control, a polishing composition that can exhibit an appropriate polishing rate corresponding to a small amount of polishing is desired, rather than a polishing composition that exhibits an excessively increased polishing rate for silicon oxide or silicon nitride. Such circumstances can be anticipated not only in forming the gate structure of field-effect transistors but also in other CMP processes in the manufacture of semiconductor devices.

In view of the above circumstances, it is an object of the present invention to provide a polishing composition that has polishing performance for a silicon layer and polishing performance for at least one of a silicon oxide layer and a silicon nitride layer, and can highly preferentially polish the silicon layer over at least one of the silicon oxide layer and the silicon nitride layer.

### Solution to Problem

A polishing composition according to the present invention includes abrasives, an amine compound, and water, in which the amine compound is at least one of 1,3-diaminopropane and 1,4-diaminobutane.

In the polishing composition according to one aspect of the present invention, the content of the amine compound is preferably 0.01 mass% or more and 1 mass% or less.

The polishing composition according to one aspect of the present invention includes no chelating agent other than the amine compound, and no oxidizing agent.

As described above, according to the present invention, it is possible to provide a polishing composition that has polishing performance for a silicon layer and polishing performance for at least one of a silicon oxide layer and a silicon nitride layer, and can highly preferentially polish the silicon layer over at least one of the silicon oxide layer and the silicon nitride layer.

### BRIEF DESCRIPTION OF DRAWINGS

Fig. 1 is a schematic cross-sectional view showing an example of an object to be polished, to which the polishing composition of the present invention can be applied.
Fig. 2 is a schematic cross-sectional view showing another example of an object to be polished, to which the polishing composition of the present invention can be applied.

### DETAILED DESCRIPTION OF EMBODIMENTS

A description will be hereinbelow given for the polishing composition according to an embodiment of the present invention.

The polishing composition of this embodiment includes abrasives, an amine compound, water, and an optional additive. The polishing composition of this embodiment is a polishing slurry in which abrasives are dispersed in water.

Examples of particles forming the abrasives include inorganic particles, organic particles, and organic-inorganic composite particles. Examples of the inorganic particles include silica particles, alumina particles, titania particles, zirconia particles, ceria particles, and calcium carbonate particles. Examples of the silica particles include fumed silica particles, colloidal silica particles, and silica particles obtained by the sol-gel method. Examples of the organic particles include organic polymer particles such as polyethylene, polypropylene, poly-1-butene, poly-4-methyl-1-pentene, olefin copolymers, polystyrene, styrene copolymers, polyvinyl chloride, polyacetal, saturated polyester, polyamide, polycarbonate, phenoxy resin, polymethyl methacrylate, (meth)acrylic resin, and acrylic copolymers. Examples of the organic-inorganic composite particles include particles obtained by polycondensation of metal or silicon alkoxide compounds (e.g., alkoxysilane, aluminum alkoxide, titanium alkoxide, etc.) in the presence of organic particles. The abrasives can be composed of only one of them or can be composed of two or more of them.

The secondary particle size of the abrasives measured by the dynamic light scattering method is preferably 500 nm or less. The secondary particle size of the abrasives is, for example, 10 nm or more.

The content of the abrasives is more preferably 0.1 mass% or more and 5.0 mass% or less, and further preferably 0.3 mass% or more and 2.5 mass% or less, based on the mass of the polishing composition.

The amine compound is at least one of 1,3-diaminopropane and 1,4-diaminobutane. That is, the polishing composition can include only one of these amine compounds or can include both of them.

The content of the amine compound is preferably 0.01 mass% or more, more preferably 0.02 mass% or more and 1 mass% or less, and further preferably 0.05 mass% or more, based on the mass of the polishing composition. The content of the amine compound is preferably 1 mass% or less.

More specifically, when the amine compound is 1,3-diaminopropane, the content thereof is preferably 0.01 mass% or more. This makes it possible to polish the polysilicon layer at a high polishing rate and to polish the silicon oxide layer and the silicon nitride layer at an appropriate polishing rate that is lower than the polishing rate of the polysilicon layer. The silicon oxide layer and the silicon nitride layer can be polished at substantially the same polishing rate.

When the amine compound is 1,4-diaminobutane, the content thereof is preferably 0.01 mass% or more and 1 mass% or less.

The mass ratio of the amine compound to the abrasives (the content of the abrasives : the content of the amine compound) is preferably 1:0.01 to 1:20, more preferably 1:0.01 to 1:15, and further preferably 1: 0.01 to 1:5.

As the water, purified water such as distilled water or ion-exchanged water is preferred. The content of the water is preferably 90 mass% or more, more preferably 95 mass% or more, further preferably 98 mass% or more, based on the mass of the polishing composition.

Examples of the additive include a water-soluble polymer. Examples of the water-soluble polymer include celluloses such as hydroxyethyl cellulose, hydroxyethyl methyl cellulose, hydroxypropyl cellulose, carboxymethyl cellulose, cellulose acetate, or methyl cellulose; vinyl polymers such as polyvinyl alcohol, modified PVA (polyvinyl alcohol derivatives), or polyvinylpyrrolidone; glycosides; and polyhydric alcohols. Examples of the glycosides include alkylene oxide derivatives of methyl glucoside such as polyoxyethylene methyl glucoside or polyoxypropylene methyl glucoside.

The polishing composition preferably includes no additive other than the above-mentioned additives. Examples of such an additive include a chelating agent such as glycine other than the amine compound, an oxidizing agent such as hydrogen peroxide solution, and an antifoaming agent such as silicone emulsions. The total content of these additives is preferably 1 mass% or less, more preferably 0.5 mass% or less, further preferably 0.1 mass% or less, based on the mass of the polishing composition. In particular, the content of each of the chelating agent and the oxidizing agent is preferably 1 mass% or less, preferably 0.5 mass% or less, more preferably 0.1 mass% or less.

The pH of the polishing composition is preferably 8 to 12, and can be 8 to 11.

When the polishing composition includes 1,3-diaminopropane, it can polish a silicon layer at 3500 Å/min or more, and polish a silicon oxide layer and a silicon nitride layer at 40 Å/min or more and 100 Å/min or less. When the polishing composition includes 1,4-diaminobutane, it can polish a silicon layer at 3500 Å/min or more and can polish the silicon nitride layer at 40 Å/min or more and 100 Å/min or less, and exhibits a lower polishing rate for the silicon oxide layer than for the silicon nitride layer (for example, less than 50%, and can be less than 40%).

Next, a description will be given for an example of use of the polishing composition while illustrating CMP in a process for forming a gate structure included in a field effect transistor of a semiconductor device.

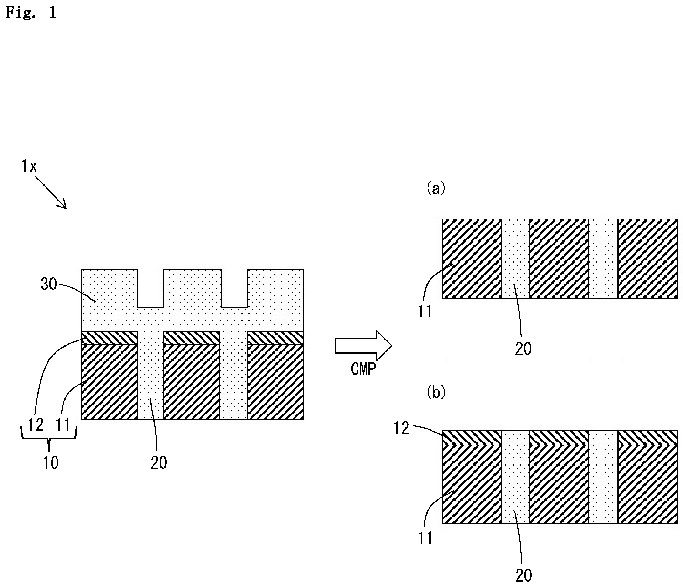

As shown in Fig. 1, an object to be polished 1x to which the polishing composition is applied, includes a plurality of ridge portions 10 each having a first layer 11 and a second layer 12 laminated on the first layer 11. The first layer 11 and the second layer 12 are formed of silicon oxide or silicon nitride. The first layer 11 and the second layer 12 are made of different materials. A recess for forming a gate electrode is formed between the ridge portions 10, and the recess is filled with silicon. That is, the object to be polished 1x includes two or more silicon-filled portions 20 between the ridge portions 10. The object to be polished 1x includes a silicon layer 30 that is laminated on the second layer 12 during silicon filling.

The layer formed of silicon oxide can be a layer formed using tetraethoxysilane (TEOS). The layer formed of silicon nitride can be a layer formed by the CVD method. The silicon of the silicon-filled portion 20 and the silicon layer 30 can be single crystal silicon, polysilicon having a polycrystalline structure, or amorphous silicon.

In the CMP of the object to be polished 1x, as shown in Fig. 1(a), following the polishing of the silicon layer 30, polishing can be performed to remove an upper end portion (the portion between each adjacent ones of the first layers 11) of the first layer 11 and the silicon-filled portion 20. In the CMP of the object to be polished 1x, as shown in Fig. 1(b), following the polishing of the silicon layer 30, polishing can be performed to planarize the exposed surface of the silicon-filled portion 20 together with the exposed surface of the second layer 12. In these CMP processes, the polishing amount of the portion composed of silicon becomes greater than the polishing amount of the portion composed of silicon oxide or silicon nitride. Therefore, the polishing composition is suitable because it can polish silicon at a relatively high polishing rate. On the other hand, in these CMP processes, the polishing amount of the portion composed of silicon oxide or silicon nitride is less than the polishing amount of the portion composed of silicon. Therefore, the polishing composition is suitable because the polishing rate for silicon oxide or silicon nitride is suppressed to be significantly lower than the polishing rate for silicon, making polishing easier to control. Thus, according to the polishing composition, the CMP for the object to be polished 1x can be performed continuously without requiring a change in composition. It is considered that such an effect is obtained by the softening of the first layer 11, the second layer 12, or the silicon layer 30 by the amine compound. Therefore, it is considered that there is no need to use specific abrasives. On the other hand, from the viewpoint of compatibility with the amine compound, the abrasives are preferably composed of colloidal silica particles.

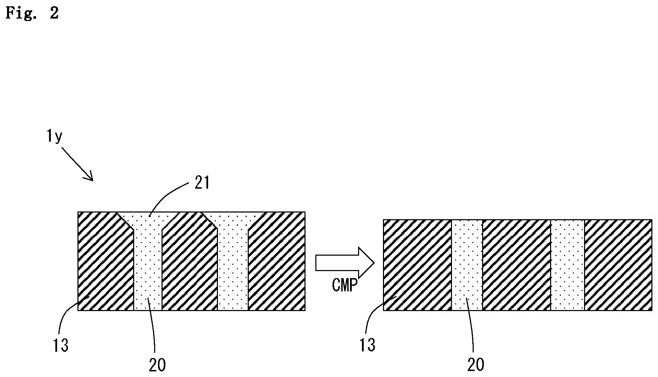

Next, as shown in Fig. 2, the object to be polished 1y to which the polishing composition is applied includes a layer 13 formed of silicon oxide or silicon nitride, and a plurality of recesses for forming gate electrodes are formed in the layer 13, and the recesses are filled with silicon. During silicon filling, the upper end portions of each pair of sidewall portions defining each of the recess are scraped off, and thereby the recess has a diameter increasing toward the upper end of the layer 13. That is, in the object to be polished 1y, an upper end portion 21 of each of the silicon-filled portions 20 has an increased diameter.

In the CMP of the object to be polished 1y, polishing can be performed in such a way that the radially expanded upper end portion 21 of the silicon-filled portion 20 and the silicon oxide layer or silicon nitride layer laterally adjacent to the upper end portion 21 are removed. In this CMP, polishing silicon at a high polishing rate is required as with the object to be polished 1x, but in addition to this, controlling the dimensions of the silicon oxide layer or silicon nitride layer is critical. In contrast, the polishing composition has a polishing rate for silicon oxide or silicon nitride that is suppressed to be significantly lower than the polishing rate for silicon, thereby making dimensional control easier.

The polishing composition of this embodiment that includes any of the above amine compounds has polishing performance for the silicon layer and polishing performance for at least one of the silicon oxide layer and the silicon nitride layer, and among these, can polish highly preferentially the silicon layer over them.

The polishing composition of this embodiment has more excellent polishing performance when the content of the amine compound is 0.01 mass% or more and 1 mass% or less.

The polishing composition of this embodiment includes no chelating agent other than the amine compound, and no oxidizing agent, thereby suppressing aggregation of abrasives and providing excellent storage stability.

As described above, an exemplary embodiment is described, but the polishing composition according to the present invention is not limited to the configuration of the above embodiment. The polishing composition according to the present invention is not limited to those having the aforementioned effect. Various modifications can be made to the polishing composition according to the present invention without departing from the gist of the present invention.

For example, the polishing composition of the present invention can be composed of the abrasives, the amine compound, the water, and the water-soluble polymer, or can be composed of the abrasives, the amine compound, and the water.

The polishing composition of the present invention includes the abrasives, the amine compound, and the water, in which the content of the abrasives is 0.1 mass% or more and 5 mass% or less, the content of the amine compound is 0.02 mass% or more and 1 mass% or less, and the content of the water can be 90 mass% or more, 95 mass% or more, or 98 mass% or more.

The polishing composition of the present invention can be prepared by diluting a concentrate, in which each component such as the abrasives or the amine compound has a higher concentration than the aforementioned concentration, with the water. For example, the concentrate for preparing the polishing composition can have a content of the abrasives of 10 mass% or more and 20 mass% or less based on the total mass of the concentrate. The concentrate is excellent in practicality in terms of transportation, but the abrasives may aggregate. From the viewpoint of suppressing such aggregation, the mass ratio of the amine compound to the abrasives in the concentrate (the content of the abrasives : the content of the amine compound) is preferably 1:0.006 or more, more preferably 1:0.01 or more, even more preferably 1:0.02 or more.

### [Examples]

The following specific examples further illustrate the invention but the present invention is not limited thereto.

Polishing compositions were prepared by mixing the amine compounds shown in Table 1, abrasives composed of colloidal silica particles (secondary particle size: 70 nm), and water. The content of the abrasives was set to 1.0 mass%. The content of the amine compound was set to 0.1 mass%. Using each polishing composition, a silicon layer, a silicon oxide layer, or a silicon nitride layer was individually polished as an object to be polished under the following polishing conditions, and the polishing rate was determined. The polishing performance was evaluated based on the following evaluation criteria. The results are as shown in Table 1.

### (Polishing conditions)

Polishing apparatus: Single-side polishing machine manufactured by SpeedFam, model "SH-24CMP" (surface plate outer diameter: 609.6 mm in diameter)
Polishing pad: IC1000 (registered trademark) manufactured by Nitta DuPont
Polishing substrate: Silicon, TEOS (film thickness: 7000 Å), p-SiN (film thickness: 2000 Å)
Polishing pressure: 3 PSI
Rotation speed: 90 rpm
Polishing time: 1 minute

### (Evaluation criteria)

∘: The polishing rate for silicon oxide or silicon nitride is 40 Å/min or more and 200 Å/min or less, and the ratio of the polishing rate for silicon to the polishing rate for silicon oxide or silicon nitride is 50 or more
×: The polishing rate for silicon oxide or silicon nitride is less than 40 Å/min, or the ratio of the polishing rate for silicon to the polishing rate for silicon oxide or silicon nitride is less than 50

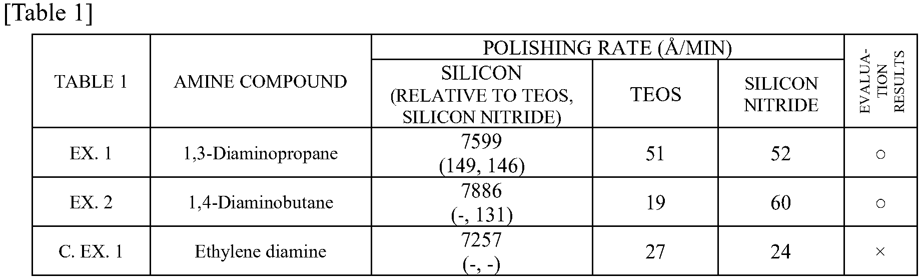

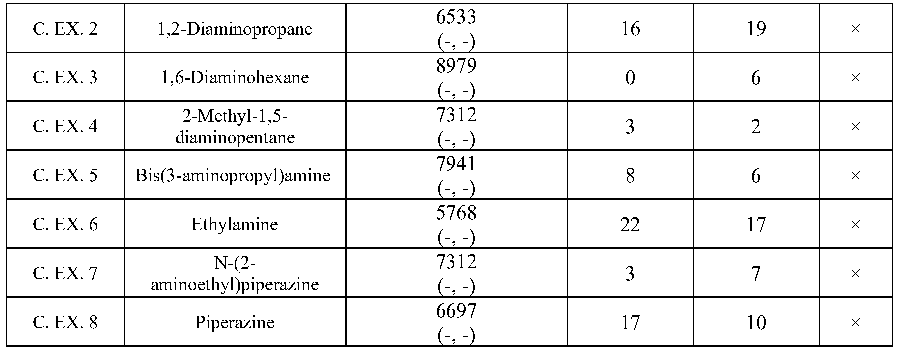

From the results of Table 1, it is recognized that Example 1 including 1,3-diaminopropane has polishing performance for any polishing target and can highly preferentially polish silicon. It is recognized that Example 2 including 1,4-diaminobutane has polishing performance for silicon and silicon nitride, and can highly preferentially polish silicon.

Next, as shown in Table 2, other amine compounds having structures similar to the amine compound of Example 1 or Example 2 were evaluated. In this evaluation, the content of the amine compound was set to 0.05 mass% (the content of the abrasives was not changed from 1.0 mass%). The results are as shown in Table 2.

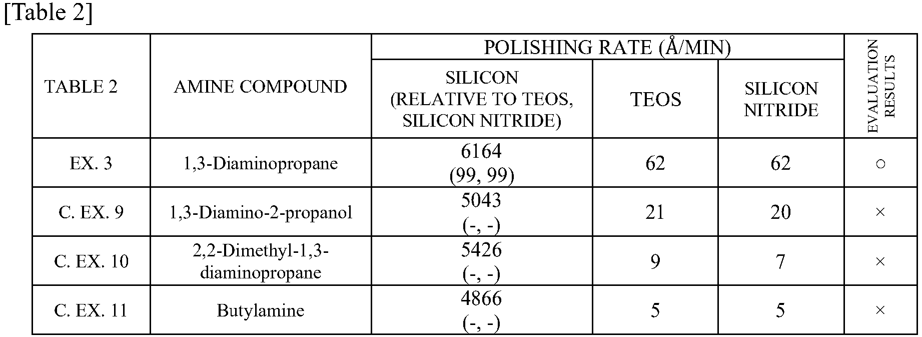

From the evaluation results of Tables 1 and 2, it can be seen that among amine compounds having a common structure, those containing 1,3-diaminopropane and 1,4-diaminobutane exhibit a desired polishing performance.

Next, as shown in Table 3, polishing compositions were prepared in the same manner as in Example 1 (abrasives: 1.0 mass%) except that the content of 1,3-diaminopropane was changed, and their polishing performances were evaluated.

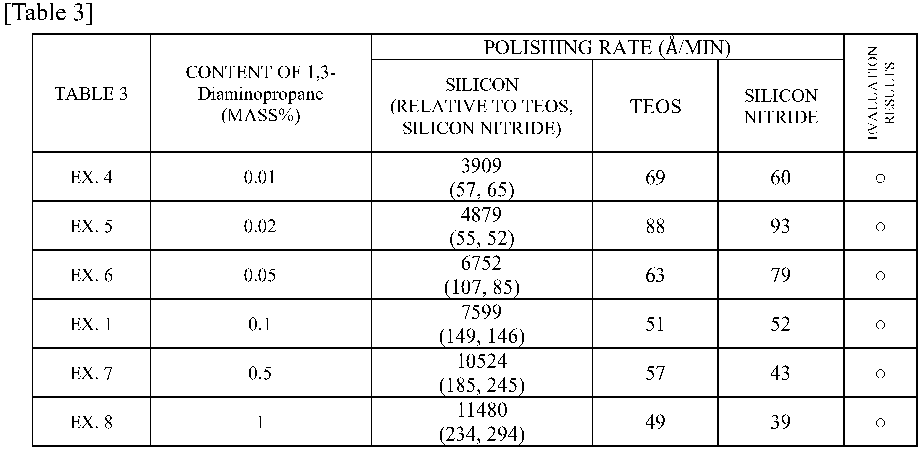

Next, as shown in Table 4, polishing compositions were prepared in the same manner as in Example 1 except that 1,3-diaminopropane was changed to an inorganic base, and their polishing performances were evaluated. However, these polishing compositions did not have a desired polishing performance.

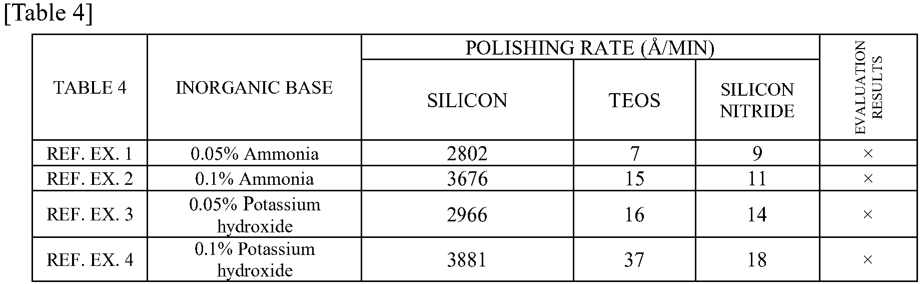

Next, as shown in Table 5, polishing compositions were prepared with the content of 1,3-diaminopropane set at 0.02 mass% and the content of abrasives changed stepwise, and their polishing performances were evaluated.

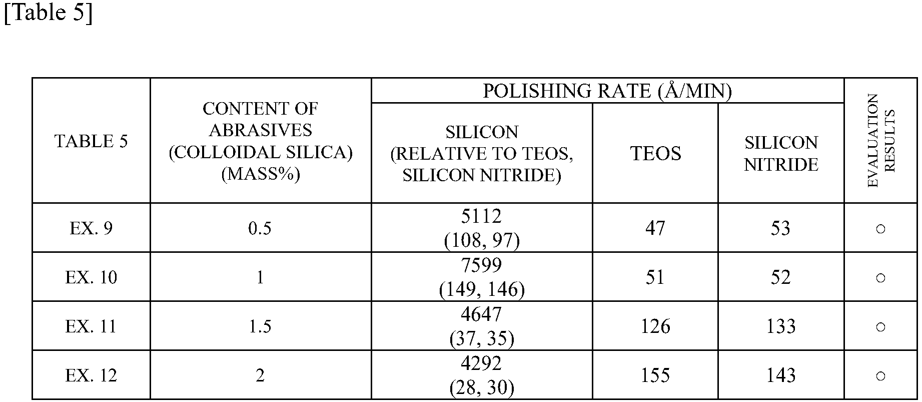

From the results of Table 5, as the amount of abrasives increases, the polishing rate for silicon shows a decreasing tendency, and accordingly, the preferential polishing performance for silicon also shows a decreasing tendency. From this, it is considered that the content of the abrasives is preferably 2 mass% or less.

Next, as shown in Table 6, polishing compositions were prepared in the same manner as in Example 5, except that a chelating agent or an oxidizing agent was added. However, these polishing compositions showed aggregation of abrasives as measured by the dynamic light scattering method and did not have practical stability.

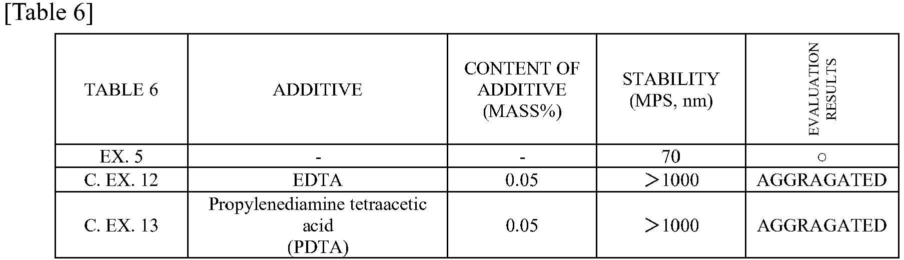

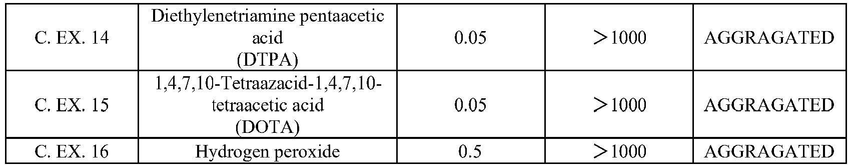

As shown in Table 7, concentrates for preparing polishing compositions were prepared with the content of abrasives set at 15 mass% and the content of 1,3-diaminopropane changed stepwise, and their stabilities were evaluated.

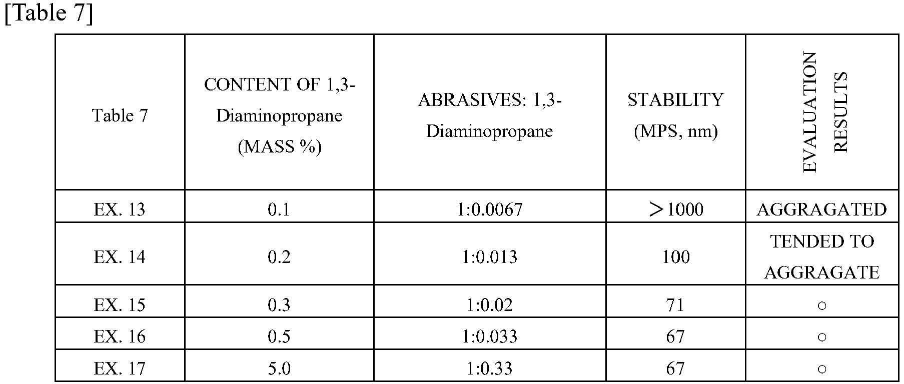

### REFERENCE SIGNS LIST

1x, 1y: Object to be polished
10: Ridge portion
11: First layer
12: Second layer
13: Layer
20: Silicon filling portion
21: Upper end portion
30: Silicon layer

## Claims

1. A polishing composition comprising abrasives, an amine compound, and water, wherein the amine compound is at least one of 1,3-diaminopropane and 1,4-diaminobutane.

2. The polishing composition according to claim 1, wherein the content of the amine compound is 0.01 mass% or more and 1 mass% or less.

3. The polishing composition according to claim 1 or 2, which comprises no chelating agent other than the amine compound, and no oxidizing agent.
